Europäisches Patentamt

European Patent Office

Office européen des brevets

(11) Publication number: **0 143 611**
**B1**

(12) **EUROPEAN PATENT SPECIFICATION**

(45) Date of publication of patent specification: 07.10.87

(51) Int. Cl.⁴: **C 23 C 16/44, B 01 D 1/14**

(21) Application number: 84308102.7

(22) Date of filing: 22.11.84

(54) **Bubbling evaporator.**

(30) Priority: 22.11.83 JP 221101/83

(43) Date of publication of application:
05.06.85 Bulletin 85/23

(45) Publication of the grant of the patent:
07.10.87 Bulletin 87/41

(84) Designated Contracting States:
DE FR GB

(56) References cited:
WO-A-81/02848
GB-A-1 559 978

PATENTS ABSTRACTS OF JAPAN, vol. 2, no.
117, September 29, 1978, page 2212 C 78

(73) Proprietor: **MITSUBISHI DENKI KABUSHIKI
KAISHA**
2-3, Marunouchi 2-chome Chiyoda-ku
**Tokyo 100 (JP)**

(72) Inventor: **Kaneno, Nobuaki c/o Mitsubishi Denki
K.K.**
**LSI Kenkyusho 1 Mizuhara, 4-chome
Itami-shi Hyogo-ken (JP)**
Inventor: **Takahashi, Kazuhisa c/o Mitsubishi
Denki K.K.**
**LSI Kenkyusho 1 Mizuhara 4-chome
Itami-shi Hyogo-ken (JP)**

(74) Representative: **Wright, Peter David John et al
R.G.C. Jenkins & Co. 12-15, Fetter Lane
London EC4A 1PL (GB)**

Courier Press, Leamington Spa, England.

# Description

The present invention relates to a bubbling evaporator for evaporating a liquid charged to the evaporator in use by the bubbling therethrough of a carrier gas.

In a process for manufacturing semiconductor devices and the like utilizing vapor deposition, a liquid organic metal or the like liquid is caused to evaporate by bubbling a carrier gas through the liquid and the vapor thus obtained and entrained with the carrier gas is employed in the vapor deposition.

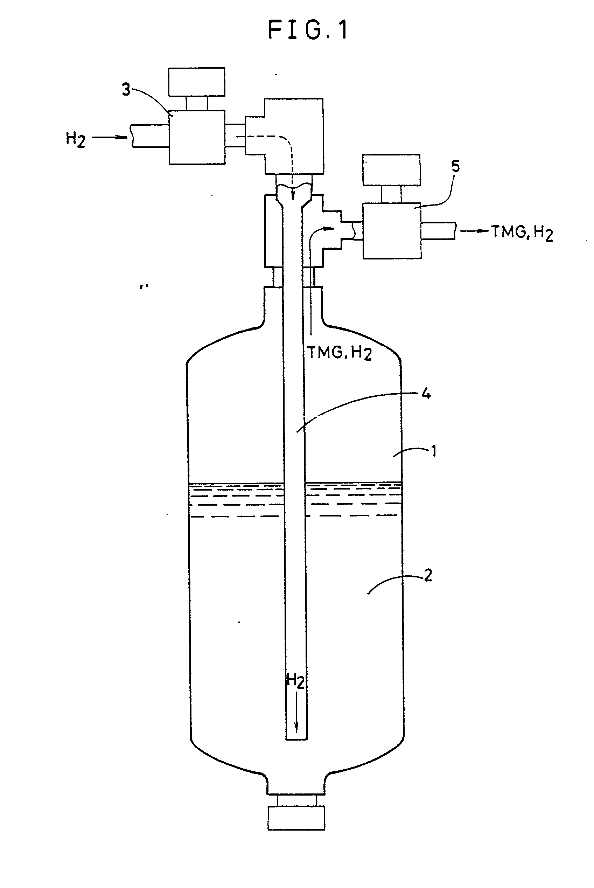

A conventional bubbling evaporator will be described with reference to Figure 1 of the accompanying drawings which is a vertical sectional view showing the construction of such a conventional evaporator.

The evaporator shown in Fig. 1 comprises a vessel 1 for containing a liquid organic metal 2 such as trimethylgallium (TMG), and an inlet pipe 4 for introducing a carrier gas such as hydrogen ($H_2$) into the liquid. In such an evaporator, the carrier gas flows through an inlet valve 3 and the inlet pipe 4 into the liquid 2 to cause bubbles therein. When these bubbles rise to the surface of the liquid, vaporization of the liquid 2 occurs and the vapor is absorbed efficiently into the bubbles. The carrier gas including such vapor is supplied to a vapor deposition station through an outlet valve 5.

However, if a backpressure arises in the vessel 1 of the above described evaporator, it might happen that a reverse flow of the liquid 2 occurs through the inlet pipe 4 into the valve 3 or pipes arranged outside the vessel 1. Such liquid may remain outside the vessel 1 not only causing a change in the vapor pressure of the evaporated liquid but also involving danger at the time of removing the vessel 1 for maintenance since such liquid organic metal is generally inflammable. In addition, although the vessel 1 is generally disposed in a constant temperature bath for the purpose of controlling the vapor pressure of the vaporized liquid, the temperature of the carrier gas is not stable and there may be a large temperature difference between the carrier gas and the liquid 2 since the carrier gas is introduced directly into the liquid 2 from outside the vessel 1 through the pipe 4. Accordingly, the vapor pressure obtained at the outlet valve 5 is not sufficiently stable.

JP—A—53-79777 discloses an evaporator comprising a vessel having an upper chamber and a lower chamber separated by a partition plate, the liquid being contained in the lower chamber in use, inlet means to the upper chamber for the carrier gas, means to convey carrier gas from the upper chamber to a point in the lower chamber below the surface of the liquid in use, whereby the carrier gas may be forced into the liquid to bubble therethrough, and outlet means from the lower chamber for the mixture of carrier gas and evaporated liquid resulting from the said bubbling.

The conveying means in the evaporator of JP—A—53-79777 extend downwardly into the liquid in the lower chamber from an aperture in the base of the upper chamber.

Whilst such a construction avoids the problem of reverse flow of the liquid in response to backpressure, it does not, however, overcome the problem of stabilizing the temperature of the carrier gas and obtaining a stable vapor pressure at the outlet of the evaporator.

An object of the present invention is to eliminate this disadvantage of the bubbling evaporator disclosed in JP—A—53-79777.

In accordance with the present invention, an evaporator is characterised in that the said conveying means has an entry in the said upper chamber for the carrier gas which entry is positioned higher than the partition plate.

A bubbling evaporator in accordance with the present invention provides a stable pressure for the vaporized liquid.

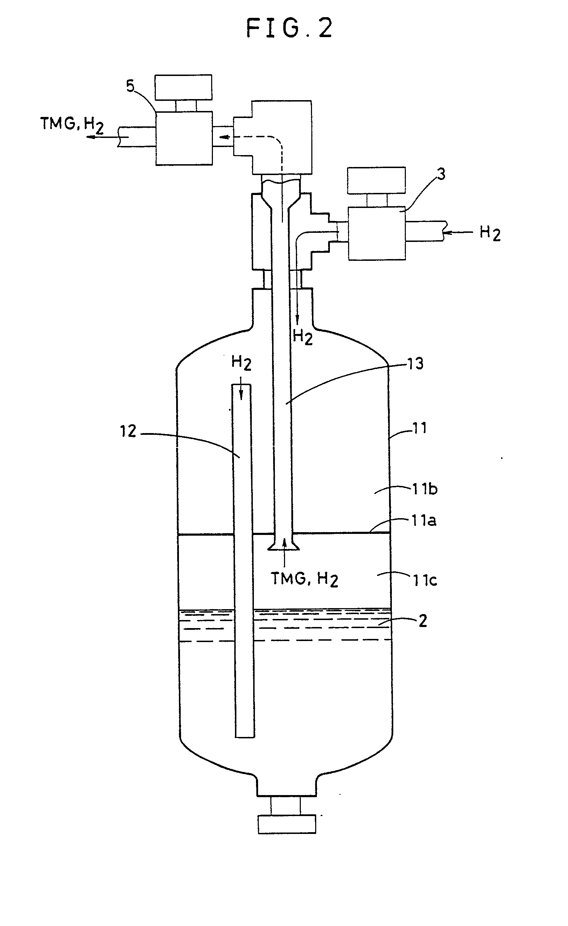

The present invention will be described further, by way of example, with reference to Figure 2 of the accompanying drawings, which is a vertical sectional view of a bubbling evaporator embodying the present invention.

Fig. 2 shows a vertical sectional view of a bubbling evaporator in accordance with the present invention. An inlet valve 3 and an outlet valve 5 shown in Fig. 2 are the same as those shown in Fig. 1. The evaporator comprises a vessel 11 divided by a partition plate 11a into an upper chamber 11b for temporarily storing a carrier gas and a lower chamber 11c for containing a liquid 2. The whole vessel 11 is disposed in a constant temperature bath (not shown). The vessel 11 further includes an inlet pipe 12 for introducing the carrier gas from the upper chamber 11b into the liquid in the lower chamber 11c through the partition plate 11a for causing the gas to bubble through and evaporate the liquid, and an outlet pipe 13 for leading the evaporated liquid entrained with the carrier gas to the exterior of the vessel 11. The outlet pipe 13 extends upward from the lower chamber 11c to the exterior of the vessel passing through substantially the centre of the upper chamber 11b.

In the evaporator, the carrier gas supplied through the inlet valve 3 is temporarily stored in the upper chamber 11b. Then, the carrier gas temporarily stored in the upper chamber 11b is conveyed through the partition plate 11a by means of the inlet pipe 12 which extends deeply into the liquid 2. The carrier gas bubbles through the liquid 2. Then, vapor obtained from the liquid 2 by bubbling the carrier gas through the liquid is led together with the carrier gas to the exterior of the vessel 11 through the outlet pipe 13 and the outlet valve 5.

In this process, the temperature of the liquid 2 is maintained stable and the temperature of the carrier gas temporarily stored in the upper chamber 11b is also made approximately equal to the temperature of the liquid 2 since the vessel 11 is provided in a constant temperature bath (not shown). Accordingly, the temperatures of the liquid 2 and the carrier gas become almost the same prior to introduction of the gas into the liquid and are maintained stable. As a result, the vapor pressure obtained at the outlet of the evaporator becomes stable.

Although as an example for the application of the bubbling evaporators described above, the supply of organic metal vapor in a process for manufacturing semiconductor devices was described, it goes without saying that a bubbling evaporator in accordance with the present invention can also be applied to other processes utilizing vapor evaporated from a liquid by bubbling a carrier gas therethrough.

## Claims

1. A bubbling evaporator for evaporating a liquid charged to the evaporator in use by the bubbling therethrough of a carrier gas, the evaporator comprising a vessel (11) having an upper chamber (11b) and a lower chamber (11c) separated by a partition plate (11a), the liquid (2) being contained in the lower chamber in use, inlet means to the upper chamber for the carrier gas, means (12) to convey carrier gas from the upper chamber (11b) to a point in the lower chamber (11c) below the surface of the liquid (2) in use, whereby the carrier gas may be forced into the liquid to bubble therethrough, and outlet means (13) from the lower chamber for the mixture of carrier gas and evaporated liquid resulting from the said bubbling, characterised in that the said conveying means (12) has an entry in the said upper chamber (11b) for the carrier gas which entry is positioned higher than the partition plate (11a).

2. A bubbling evaporator according to claim 1 in which the said outlet means (13) extends upward from the said lower chamber (11c) to the exterior of said vessel, passing through substantially the center of the said upper chamber (11b).

## Patentansprüche

1. Sprudelnder Verdampfer zum Verdampfen einer Flüssigkeit, mit der der in Benutzung stehende Verdampfer beaufschlagt ist, durch Durchblasen eines Treibgases dadurch, wobei der Verdampfer ein Gefäß (11) mit einer oberen Kammer (11b) und einer unteren Kammer (11c), die durch eine Trennungsplatte (11a) getrennt sind, wobei die Flüssigkeit (2) in der unteren Kammer während der Benutzung enthalten ist, eine Einlaßeinrichtung für das Trägergas zu der oberen Kammer, einer Einrichtung (12) zum Befördern des Trägergases von der oberen Kammer (11b) zu einem Punkt in der unteren Kammer (11c) unterhalb der Oberfläche der Flüssigkeit (2) in Benutzung, wodurch das Trägergas in die Flüssigkeit zum Durchperlen gezwungen werden kann, und einer Auslaßeinrichtung (13) aus der unteren Kammer für das Gemisch von Trägergas und der verdampften Flüssigkeit, die aus dem Durchperlen resultiert, aufweist, dadurch gekennzeichnet, daß die Beförderungseinrichtung (12) einen Eintritt in die obere Kammer (11b) für das Trägergas aufweist, welcher Eintritt höher als die Trennungsplatte (11a) angeordnet ist.

2. Sprudelnder Verdampfer nach Anspruch 1, in dem die Auslaßeinrichtung (13) sich aufwärts von der unteren Kammer (11c) in den Außenraum des Gefäßes erstreckt, wobei sie im wesentlichen durch das Zentrum der oberen Kammer (11b) geht.

## Revendications

1. Evaporateur bouillonnant destiné à l'évaporation d'un liquide chargé dans l'évaporateur en utilisation, en faisant barboter à travers le liquide un gaz porteur, l'évaporateur comprenant un récipient (1) comportant une chambre supérieure (11b) et une chambre inférieure (11c) séparées par une plaque de séparation (11a), le liquide (2) étant contenu dans la chambre inférieure en cours d'utilisation, des moyens d'entrée vers la chambre supérieure et destinés au gaz porteur, des moyens (12) pour acheminer le gaz porteur de la chambre supérieure (11b) vers un point de la chambre inférieure (11c) situé au-dessous de la surface du liquide (2) pendant l'utilisation, le gaz porteur étant ainsi forcé de traverser le liquide par barbotage, et un moyen de sortie (13) partant de la chambre inférieure et destiné au mélange de gaz porteur et de liquide évaporé provenant dudit barbotage, caractérisé en ce que lesdits moyens d'acheminement (12) comprennent une entrée dans ladite chambre supérieure (11b), destinée au gaz porteur, cette entrée étant disposée à un niveau supérieur à celui de la plaque de séparation (11a).

2. Evaporateur bouillonnant selon la revendication 1, dans lequel ledit moyen de sortie (13) s'étend vers le haut à partir de ladite chambre inférieure (11c) et vers l'extérieur dudit récipient, en passant sensiblement par le centre de ladite chambre supérieure (11b).

# FIG.1

H₂ →

3

5

→ TMG, H₂

TMG, H₂

4

1

2

H₂

# FIG.2